# FASCICULE DE BREVET EUROPEEN

(11) **EP 0 877 478 B1**
(45) Date de publication et mention de la délivrance du brevet: **06.10.2004**
(21) Numéro de dépôt: 98201374.0
(22) Date de dépôt: 28.04.1998
(51) Int. Cl.: H03F 3/193, H03F 1/34

(54) **"Dispositif incluant un circuit amplificateur large-bande"**
Vorrichtung mit einer Breitbandverstärkerschaltung
Apparatus with a wide band amplifier circuit

(30) Priorité: 07.05.1997 FR 9705670
(43) Date de publication de la demande: 11.11.1998
(73) Titulaire: Koninklijke Philips Electronics N.V., 5621 BA Eindhoven (NL)
(72) Inventeur: Jean, Patrick, 75008 Paris (FR); Rousseau, Isabelle, 75008 Paris (FR)
(74) Mandataire: Landousy, Christian

(56) Documents cités:
- EP-A- 0 161 885
- J.A. ARCHER ET AL: "A GaAs MONOLITHIC LOW-NOISE BROAD-BAND AMPLIFIER" IEEE JOURNAL OF SOLID-STATE CIRCUITS., vol. sc-16, no. 6, décembre 1981, pages 648-652, XP002052619 NEW YORK US
- KENJIRO NISHIKAWA ET AL: "AN MMIC LOW-DISTORTION VARIABLE-GAIN AMPLIFIER USING ACTIVE FEEDBACK" IEEE TRANSACTIONS ON MICROWAVE THEORY AND TECHNIQUES, vol. 43, no. 12, PART 02, 1 décembre 1995, pages 2812-2816, XP000549430
- FOUQUET F ET AL: "BROADBAND MMIC AMPLIFIER WITH ACTIVE MATCHING" PROCEEDINGS OF THE 23RD. EUROPEAN MICROWAVE CONFERENCE, MADRID, SEPT. 6 - 9, 1993, 6 septembre 1993, page 829/830 XP000630008 EUROPEAN MICROWAVE CONFERENCE MANAGEMENT COMMITTEE

## Description

L'invention concerne un dispositif incluant un circuit amplificateur large-bande.

L'invention trouve son application dans l'industrie de fabrication des appareils de télécommunication récepteur et/ou émetteur, sans fil et/ou raccordés.

Un amplificateur large-bande est déjà connu par la publication : IEEE JOURNAL OF SOLID STATE CIRCUITS, VOL.SC-16, N°6, DECEMBER 1981 "A GaAs Monolithic Low-Noise Broad-band Amplifier", John A. ARCHER, Herbert P. WEIDLICH et alii.

Cette publication décrit un amplificateur large bande formant un circuit monolithiquement intégré en GaAs. Ce circuit amplificateur comprend deux étages ayant chacun un transistor amplificateur et un transistor de charge. Les transistors sont tous du type normalement passant en l'absence de tension de polarisation grille-source. La tension d'équilibre dépend fortement de la similitude des transistors amplificateur et de charge, donc lesdits transistors sont identiques dans chaque étage et polarisés à tension grille-source nulle. A cet effet, d'une part, la source des transistors amplificateurs est reliée à la masse et leur grille est reliée à la masse à travers une résistance, et d'autre part la source et la grille des transistors de charge sont reliées entre elles et au drain des transistors amplificateurs. Ce circuit comprend en outre, dans chaque étage, une résistance de contre-réaction branchée entre le drain et la grille du transistor amplificateur du dit étage. Dans ce circuit, il a été trouvé que la tension disponible sur le drain de chaque transistor amplificateur est extrêmement sensible à l'appariement des transistors amplificateur et de charge, d'où il résulte un problème lorsque le circuit doit être fabriqué en grande série, car dans ces conditions les caractéristiques des transistors sont généralement dispersées. Donc le risque est des pertes de fabrication.

Un but de la présente invention est de fournir un dispositif avec un circuit amplificateur large-bande qui résout plusieurs problèmes dont :
être insensible à l'appariement des transistors amplificateur et de charge, de manière à pouvoir être inclus dans des dispositifs fabriqués en grande série ;
avoir un gain en continu très grand, pour permettre de polariser les transistors avec des moyens de polarisation simples ;
avoir une réponse en fréquence est très plate.

Selon l'invention ces problèmes sont résolus par un dispositif incluant un circuit amplificateur large-bande dans lequel le circuit amplificateur comprend au moins deux étages à transistors à effet de champ, avec des transistors bas montés en amplificateurs et des transistors hauts montés en charge, et dans lequel le signal de sortie d'un étage donné autre que le premier étage est amené en contre-réaction sur sa propre entrée à travers une branche de contre-réaction comprenant au moins ledit transistor haut de l'étage précédant ledit étage donné.

Ce dispositif présente entre autres les avantages que la variation du gain de l'amplificateur en fonction de la température est extrêmement faible devant les variations habituellement constatées dans des amplificateurs connus et que les variations de son gain en fonction des dispersions des caractéristiques des éléments du circuit lors de la fabrication sont très faibles.

Un dispositif est décrit ci-après en détail en référence à des figures schématiques annexées comprenant :
les FIGS.1 et FIG.2 représentant respectivement un premier et un second exemples de circuit amplificateur ;
la FIG.3 représentant des courbes de gain G et de facteur de bruit B en fonction de la fréquence F ;
la FIG.4 représentant un dispositif de télécommunication incluant un tel circuit amplificateur.

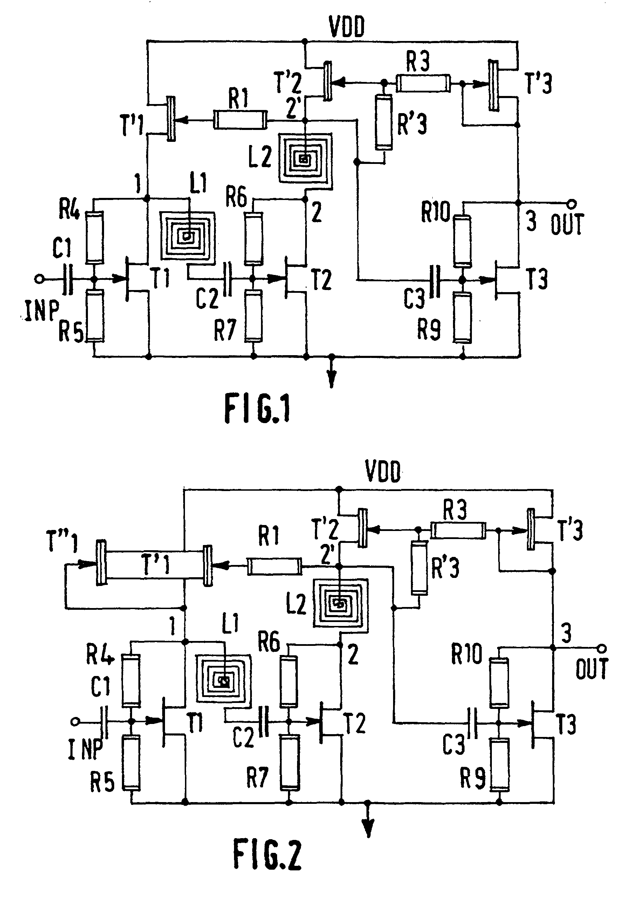

En référence à la FIG.1, dans un premier mode de réalisation donné à titre d'exemple, un circuit amplificateur 100 comprend trois étages amplificateurs montés en série. Les trois étages comprennent respectivement un transistor bas T1, T2, T3 et un transistor haut T'1, T'2, T'3 montés entre la masse et une alimentation de tension continue VDD. Les transistors sont du type à effet de champ avec chacun des électrodes de grille, source et drain. Lesdits transistors bas T1, T2, T3 qui ont la fonction amplificateur sont du type appelé N-OFF non passant en l'absence de tension de polarisation grille-source. Lesdits transistors hauts T'1, T'2, T'3 qui ont la fonction charge sont du type appelé N-ON passant en l'absence de tension de polarisation grille-source. La différence de type des transistors bas et haut, dont les uns sont N-OFF et les autres N-ON est un élément technique important de l'invention.

Dans le circuit de la FIG.1, le premier étage amplificateur comprend le transistor bas N-OFF T1, dont la source est à la masse, dont la grille reçoit un signal d'entrée alternatif au noeud INP à travers une capacité C1 d'isolation en continu et dont le drain est connecté au noeud 1 à la source du transistor haut N-ON T'1. Ce transistor haut T'1 N-ON, servant de charge, a son drain connecté à l'alimentation en continue VDD et sa source connectée au noeud 1 au drain du transistor bas T1. En outre, des résistances R4, R5 sont montées en pont de résistances entre le drain 1, la grille et la source à la masse du transistor bas T1 pour assurer la polarisation de grille.

Dans le circuit de la FIG.1, le second étage amplificateur comprend le transistor bas N-OFF T2, dont la source est à la masse, dont la grille reçoit le signal alternatif de sortie du premier étage disponible au noeud 1 et appliqué sur ladite grille du transistor bas T2 à travers une self L1 et une capacité d'isolation en continu C2. Le transistor haut T'2 sert de charge et a son drain connecté à l'alimentation en continu VDD et sa source connectée au drain du transistor bas T2 par une self L2 disposée entre un noeud 2' vers la source du transistor T'2 et un noeud 2 vers le drain du transistor T2. Des résistances de polarisation R6, R7 sont montées en pont de résistances entre le drain 2, la grille et la source à la masse du transistor bas T2 pour assurer sa polarisation de grille.

En outre, une résistance R1 est connectée entre la source 2' du transistor haut T2 du deuxième étage et la grille du transistor haut T'1 du premier étage. En sorte que le signal de sortie du deuxième étage, qui est disponible sur le drain du transistor bas T2 au noeud 2, est ramené au noeud 1 sur le drain du transistor bas T1 du premier étage, à travers ladite self L2, ladite résistance R1 et le ledit transistor haut T'1 du premier étage.

Ce transistor haut T'1 du premier étage a alors partiellement une fonction de charge active et partiellement une fonction de contre-réaction. D'une part, ce transistor haut T1 fait partie de la boucle de contre-réaction incluant L2 et R1, et d'autre part il forme une charge pour le transistor bas T1, charge contrôlée par le signal de sortie du deuxième étage disponible au noeud 2.

Dans le circuit de la FIG.1, le troisième étage comprend le transistor bas N-OFF T3, dont la source est à la masse, dont la grille reçoit le signal alternatif de sortie du second étage disponible au noeud 2 et appliqué sur ladite grille du transistor bas T3 à travers d'une part ladite self L2 qui est disposée entre les noeuds 2 et 2' du second étage, et à travers d'autre part une capacité d'isolation en continu C3. Le transistor haut T'3 a son drain connecté à l'alimentation en continu VDD et sa source connectée au drain du transistor bas T3. Des résistances de polarisation R10, R9 sont montées en pont de résistances entre le drain 3, la grille et la source à la masse du transistor bas T3 pour assurer sa polarisation de grille. On notera la particularité constituée par le fait de prélever le signal du troisième étage au moyen de la self L2 en série au lieu d'une self entre étages comme L1. Cette particularité permet d'obtenir une réponse en fréquence plus plate pour l'amplificateur.

En outre, le transistor haut T3 a sa grille connectée directement à sa source pour constituer une vraie charge active, au sens habituel de la technique, pour le transistor bas T3. De plus, une résistance R3 est connectée entre le drain 3 du transistor bas T3 et la grille du transistor haut T'2. Le signal de sortie du troisième étage, qui est disponible sur le drain du transistor bas T3 au noeud 3 est ramené sur le drain du transistor bas T2 du deuxième étage au noeud 2 à travers ladite résistance R3 et ledit transistor haut T'2 du deuxième étage.

Ce transistor haut T2 du deuxième étage a alors partiellement une fonction de charge et partiellement une fonction de contre-réaction. D'une part, ce transistor haut T'2 fait partie de la boucle de contre-réaction incluant R3 et L2, et d'autre part il forme une charge pour le transistor bas T2, cette charge étant contrôlée par le signal de sortie du troisième étage disponible au noeud 3. Le taux de contre-réaction entre le troisième et le second étages n'est pas exactement égal à 1 parce que ce taux de contre-réaction est contrôlé par le pont de résistances R3, R'3 qui forme un diviseur de tension. Ainsi, en fonction des valeurs de ces résistances on ajuste le taux de contre-réaction pour obtenir une fréquence de coupure appropriée pour l'amplificateur. Par contre, le taux de contre-réaction du second étage vis-à-vis du premier étage est contrôlé par la façon de réaliser la charge du premier étage.

Le dernier étage T3 a une charge active pure par exemple si l'on n'a pas de quatrième étage pour fournir une contre-réaction liée au troisième étage. Il est avantageux pour le fonctionnement du circuit amplificateur d'avoir au moins un étage amplificateur ayant une vraie charge active qui détermine la tension de polarisation de drain du transistor bas de l'étage concerné et également celle des autres étages amplificateurs.

Dans une généralisation de l'invention, un circuit amplificateur a au moins deux étages amplificateurs successifs dont le deuxième étage fournit une contre-réaction liée au premier étage. Ainsi dans l'exemple décrit plus haut, les deux premiers étages ont une charge qui a aussi un rôle de contre-réaction. La fonction d'une telle boucle de contre-réaction est d'amener au drain d'un transistor d'un étage précédent un signal en opposition de phase disponible au drain d'un étage donné de manière à pouvoir réintroduire ce signal sur la grille dudit transistor donné. Ainsi, dans le transistor du deuxième étage, la grille se voit appliquer un signal provenant du drain dudit transistor et en opposition de phase avec le signal arrivant normalement sur ladite grille. En effet, la sortie du transistor bas T1, sur son drain au noeud 1, est transmise à 'entrée du transistor bas T2 sur sa grille. Ensuite, le signal de sortie du transistor bas T2 est retransmis à l'entrée de ce même transistor T2 par l'intermédiaire du transistor haut T'1, agissant en transistor suiveur. Au passage le transistor bas T1 amplifie le signal porté à son entrée INP, mais n'agit pas dans la contre-réaction. En fait, la contre-réaction est appliquée sur la sortie du premier étage. Un tel circuit formé au moins des deux étages T1, T'1 et T2, T'2 respectivement constitue un amplificateur à gain plat.

Dans la constitution des contre-réactions dans le circuit amplificateur 100, on peut prévoir une contre-réaction différente en haute fréquence et en basse fréquence. A cet effet, on tient compte du fait que le gain de l'amplificateur baisse spontanément quand la fréquence augmente car l'impédance d'entrée qui est équivalente à une capacité forme un filtre R-C avec les charges. En calculant d'une manière précise connue de l'homme du métier les valeurs des différents éléments du circuit, on obtient la maîtrise des valeurs de contre-réaction dans les différents étages. Il est alors avantageux de prévoir les valeurs desdits éléments telles que les contre-réactions sont fortes en BF et moins fortes en HF. Il en résulte l'avantage que le circuit amplificateur montre un gain plus plat sur une plus grande largeur de bande de fréquences. Pour affaiblir la contre-réaction en HF, il est favorable de calculer les valeurs des éléments pour construire des étages où le signal de contre-réaction arrive non pas complètement en opposition de phase, mais avec une autre différence de phase prédéterminée, par exemple en quadrature de phase.

Dans le circuit de la FIG.1, le taux de contre-réaction du second étage vis-à-vis du premier est proche de 1 au sens de l'atténuation. Mais ce taux de 1 n'est pas un taux réel, car s'il en était autrement, l'amplificateur ne montrerait aucun gain, ce qui n'est pas le cas. Le taux de contre-réaction entre les premier et second étages de la FIG.1 est en dépendance des transconductances des transistors hauts T'1 et T'2.

On notera que la résistance R1 constitue avec la capacité d'entrée du transistor haut T'1 un filtre passe-bas R-C réglé pour améliorer la bande passante. D'autre part, les selfs L1 et L2 sont accordées sur les capacités d'entrée des transistors bas.

En référence à la FIG.2, l'amplificateur 100 à gain plat de la FIG.1 est modifié en ce que le transistor haut du premier étage est partagé en deux transistors montés avec leurs drains réunis et leur sources réunies. Un de ces deux transistors noté T'1 est monté exactement comme le transistor T'1 de la FIG.1 et a dans le cas du circuit de la FIG.2, seulement la fonction de participer à la contre-réaction décrite plus haut. Le second de ces deux transistors, noté T' '1, a seulement une fonction de charge et à cet effet sa grille est reliée à sa source. Encore dans ce circuit de la FIG.2, tous les transistors bas sont d'un type différent de ceux des transistors hauts. Avec une alimentation VDD positive, les transistors bas sont du type N-OFF et les transistors hauts sont du type N-ON. L'utilisation d'une alimentation VDD positive est particulièrement avantageux lorsqu'un circuit 100 est inclus dans un dispositif portable ou sans fil, alimenté par batteries.

Dans le circuit de la FIG.2, le taux de contre-réaction est en dépendance de la taille du transistor de contre-réaction T'1. Dans un exemple favorable, les tailles des transistors T'1 et T"1 sont substantiellement égales et dans ce cas le taux de contre-réaction est proche de 0,5. Un avantage des circuits amplificateurs 100 des FIG.1 et 2 est que le gain en continu est très grand, environ 10, ce qui permet de réaliser la polarisation des étages avec des moyens simples constitués par les ponts de résistances.

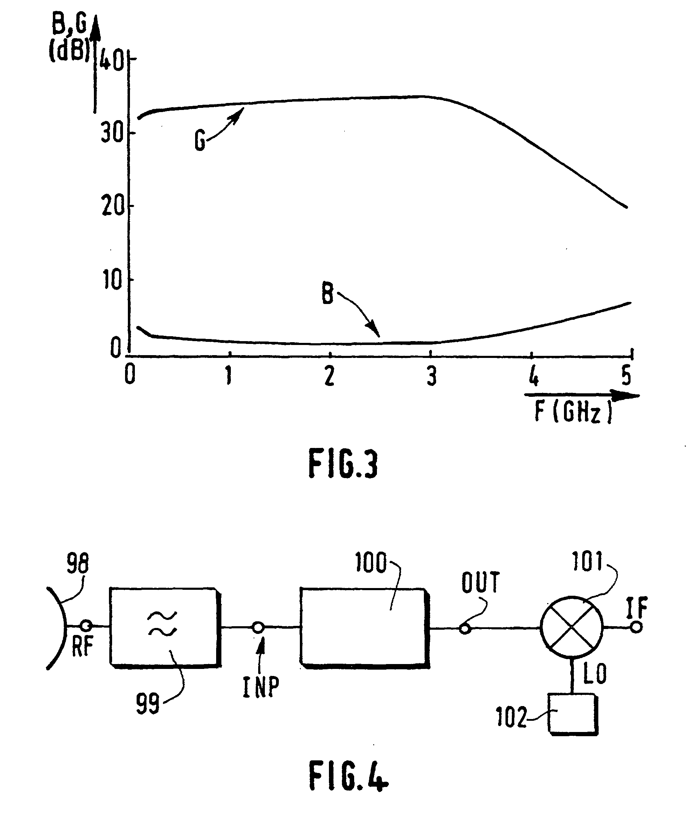

Les circuits des FIG.1 et 2 pourraient fonctionner avec des transistors hauts et bas de même type, mais ils n'auraient pas de gain substantiel. En référence à la FIG.3, le circuit amplificateur 100 de la FIG.2 montre un gain plat G d'environ 35dB entre quelques Hz et 3GHz, et un gain de plus de 20dB jusqu'à 5GHz. Ce circuit montre un facteur de bruit B faible et très constant dans la même gamme de fréquence F.

Un circuit amplificateur 100 tel que décrit plus haut est inclus dans un dispositif pour télécommunications. A titre d'exemple, la FIG.4 montre un dispositif de réception radiofréquence qui comprend : un filtre radiofréquence 99 recevant un signal RF provenant d'une antenne 98, et relié à l'entrée INP de l'amplificateur 100 ; le circuit amplificateur 100 ayant une sortie notée OUT; et un mélangeur 101 recevant en entrée la sortie OUT de l'amplificateur 100 et un signal LO d'un oscillateur local 102 et fournissant une sortie à une fréquence intermédiaire IF. Un dispositif incluant un tel circuit amplificateur 100 montre entre autres avantages peu de dispersions en fonction de la fréquence et en fonction de la température, et un facteur de bruit très constant.

## Revendications

1. Dispositif incluant un circuit amplificateur large-bande dans lequel le circuit amplificateur comprend au moins deux étages à transistors à effet de champ, avec des transistors bas (T1, T2) montés en amplificateurs et des transistors hauts (T'1, T'2) montés en charge, et dans lequel le signal de sortie d'un étage donné autre que le premier étage est amené en contre-réaction sur sa propre entrée à travers une branche de contre-réaction comprenant au moins ledit transistor haut (T'1) de l'étage précédant ledit étage donné (T2).

2. Dispositif selon la revendication 1, dans lequel lesdits transistors hauts (T'1, T2) du circuit amplificateur sont d'un type différent des transistors bas (T1, T2).

3. Dispositif selon l'une des revendications 1 ou 2, dans lequel ledit transistor haut (T'1) dudit étage précédent entrant dans ladite branche de contre-réaction est seul pour assurer la fonction de charge et la fonction de contre-réaction.

4. Dispositif selon l'une des revendications 1 ou 2, dans lequel ledit transistor haut dudit étage précédent est double, ayant une première partie de transistor (T'1) entrant dans ladite branche de contre-réaction et une seconde partie de transistor (T'2) assurant la fonction de charge.

5. Dispositif selon l'une des revendications 1 à 4, dans lequel des selfs (L1, L2) sont induses dans la ou les branches de contre-réaction et accordées sur les impédances d'entrée des transistors bas (T1, T2) pour assurer une réponse de l'amplificateur plus plate en fréquence.

6. Dispositif selon l'une des revendications 1 à 5, dans lequel un pont de résistances (R4, R5 ; R6, R7 ; R10, R9) est placé entre le drain, la grille et la source à la masse des transistors bas (T1, T2, T3) pour assurer la polarisation de grille.

7. Dispositif selon l'une des revendications 1 à 6 ayant trois étages amplificateurs (T1, T2, T3), avec deux étages successifs (T1, T2) liés par une branche de contre-réaction, et avec un étage (T3) ayant une vraie charge active (T'3) constituée par un transistor haut.

8. Dispositif selon la revendication 7, dans lequel un pont de résistances diviseur de tension (R3, R'3) est placé dans une branche de contre-réaction pour régler le taux de contre-réaction.

9. Dispositif de télécommunications **caractérisé en ce qu'**il comprend un dispositif selon l'une des revendications 1 à 8.

10. Dispositif récepteur radiofréquence équipé d'un dispositif selon l'une des revendications 1 à 8, comprenant, outre le circuit amplificateur (100) large bande, un filtre radiofréquence (99) recevant un signal (RF) provenant d'une antenne (98) et relié à l'entrée (INP) de l'amplificateur (100) et un circuit mélangeur (101) recevant la sortie (OUT) de l'amplificateur (100) et un signal (L0) d'un oscillateur local (102) pour fournir un signal (IF) à une fréquence intermédiaire.

## Claims

1. A device including a broadband amplifier circuit in which the amplifier circuit comprises at least two field effect transistor stages, with low transistors (T1, T2) arranged as amplifiers and high transistors (T'l, T'2) arranged as loads, and in which the output signal of a given stage other than the first stage is fed back to its own input through a feedback branch which comprises at least said high transistor (T'1) of the stage preceding said given stage (T2).

2. A device as claimed in claim 1, in which said high transistors (T'1, T'2) of the amplifier circuit are of a type that differs from the low transistors (T1, T2).

3. A device as claimed in one of the claims 1 or 2, in which said high transistor (T'1) of said preceding stage entering said feedback branch is a sole transmitter to ensure the load function and the feedback function.

4. A device as claimed in one of the claims 1 or 2, in which said high transistor of said preceding stage is double, having a first transistor part (T'1) entering said feedback branch and a second transistor part (T'2) ensuring the load function.

5. A device as claimed in one of the claims 1 to 4, in which the self-impedance elements (L1, L2) are included in the feedback branch(es) and are attuned to the input impedances of the low transistors (T1, T2) to ensure a flatter frequency response of the amplifier.

6. A device as claimed in one of the claims 1 to 5, in which a resistor bridge (R4, R5; R6, R7; R10, R9) is inserted between the drain, the gate and the grounded source of the low transistors (T1, T2, T3) to ensure the biasing of the gate.

7. A device as claimed in one of the claims 1 to 6 having three amplifier stages (T1, T2, T3) with two successive stages (T1, T2) connected by a feedback branch and with one stage (T3) having a real active load (T'3) formed by a high transistor.

8. A device as claimed in claim 7, in which a resistor bridge which is a voltage divider (R3, R'3) is inserted into a feedback branch to control the feedback ratio.

9. A telecommunications device, **characterized in that** it comprises a device as claimed in one of the claims 1 to 8.

10. A radio frequency receiver device including a device as claimed in one of the claims 1 to 8, comprising in addition to the broadband amplifier circuit (100) a radio frequency filter (99) receiving a signal (RF) coming from an antenna (98) and connected to the input (INP) of the amplifier (100) and a mixer circuit (101) receiving the output signal (OUT) of the amplifier (100) and a signal (LO) of a local oscillator (102) to produce an intermediate frequency signal (IF).

## Patentansprüche

1. Vorrichtung mit einer Breitband-Verstärkerschaltung, in der die Verstärkerschaltung mindestens zwei Stufen mit Feldeffekt-Transistoren aufweist, mit als Verstärker geschalteten unteren Transistoren (T1, T2) und als Ladung geschalteten oberen Transistoren (T'1, T'2), und in dem das Ausgangssignal einer bestimmten Stufe außer der ersten Stufe über einen mindestens den besagten oberen Transistor (T'1) enthaltenden Gegenreaktionszweig der der besagten bestimmten Stufe vorhergehenden Stufe (T2) in Gegenreaktion an seinen eigenen Eingang geleitet wird.

2. Vorrichtung nach Anspruch 1, in dem die besagten oberen Transistoren (T'1, T'2) der Verstärkerschaltung eines zu den unteren Transistoren (T1, T2) unterschiedlichen Typs sind.

3. Vorrichtung nach einem der Ansprüche 1 oder 2, in dem der besagte obere Transistor (T1) der besagten vorhergehenden Stufe, welche in den besagten Gegenreaktionszweig kommt, alleine ist, um die Funktion der Ladung und die Funktion der Gegenreaktion zu versichern.

4. Vorrichtung nach einem der Ansprüche 1 oder 2, in dem der besagte obere Transistor der besagten Vorhergehenden Stufe doppelt ist, mit einem ersten Teil des Transistors (T 1 ), welcher in den besagten Gegenreaktionszweig kommt, und einem zweiten Teil des Transistors (T2), welcher die Funktion der Ladung versichert.

5. Vorrichtung nach einem der Ansprüche 1 bis 4, in dem Drosselspulen (L1, L2) in dem oder den Gegenreaktionszweigen enthalten sind und auf die Eingangsimpedanzen der unteren Transistoren (T1, T2) abgestimmt werden, um eine Reaktion des Verstärkers mit flacherer Frequenz zu versichern.

6. Vorrichtung nach einem der Ansprüche 1 bis 5, in dem eine Widerstandsbrücke (R4, R5; R6, R7; R10, R9) zwischen dem Drain, dem Gate und der Source an die Masse der unteren Transistoren (T1, T2, T3) angebracht ist, um die Gate-Polarisation zu versichern.

7. Vorrichtung nach einem der Ansprüche 1 bis 6 mit drei Verstärkerstufen (T1, T2, T3) mit zwei aufeinanderfolgenden Stufen (T1, T2), die über einen Gegenreaktionszweig verbunden sind, und einer Stufe (T3) mit einer echten aktiven Ladung (T3), die von einem oberen Transistor gebildet wird.

8. Vorrichtung nach Anspruch 7, in dem eine Spannungsteiler-Widerstandsbrücke (R3, R'3) in einem Gegenreaktionszweig angebracht ist, um das Gegenreaktionsverhältnis zu regeln.

9. Telekommunikationsvorrichtung, **dadurch gekennzeichnet, dass** sie eine Vorrichtung nach einem der Ansprüche 1 bis 8 aufweist.

10. Hochfrequenz-Empfangsvorrichtung, mit einer Vorrichtung nach einem der Ansprüche 1 bis 8 ausgerüstet, mit, neben der Breitband-Verstärkerschaltung (100) einem Hochfrequenzfilter (99), der ein von einer Antenne (98) kommendes Signal (HF) erhält und mit dem Eingang (INP) des Verstärkers (100) verbunden ist, und einer Mischerschaltung, (101) die den Ausgang (OUT) des Verstärkers (100) und ein Signal (LO) eines lokalen Oszillators (102) erhält, um ein Signal (IF) mit einer Zwischenfrequenz auszugeben.
